# EUROPEAN PATENT SPECIFICATION

(11) **EP 1 623 452 B1**
(45) Date of publication and mention of the grant of the patent: **22.11.2006**
(21) Application number: 04760895.5
(22) Date of filing: 06.05.2004
(51) Int. Cl.: H01L 21/00, C23C 16/458

(54) **WIDE TEMPERATURE RANGE CHUCK SYSTEM**
HALTERUNGSSYSTEM EINSETZBAR ÜBER EINEN BREITEN TEMPERATURBEREICH
SYSTEME DE MANDRINS A LARGE PLAGE DE TEMPERATURE

(30) Priority: 07.05.2003 US 469050 P
(43) Date of publication of application: 08.02.2006
(73) Proprietor: Axcelis Technologies Inc., Beverly, MA 01915-1053 (US)
(72) Inventor: WANG, Albert, Moraga, CA 94556 (US)
(74) Representative: Heuckeroth, Volker
(86) International application number: PCT/US2004/014093
(87) International publication number: WO 2004/102640

(56) References cited:
- US-B1- 6 461 801

## Description

### Field of the Invention

The present invention relates generally to temperature control of workpiece support chucks for semiconductor processing equipment, and more particularly to rapid heating and cooling of such chucks.

### Background of the Invention

In many semiconductor processing steps, such as etching, deposition, annealing, etc., a workpiece (*e.g.*, a silicon wafer, glass substrate, etc.) is supported within a processing chamber. Gaseous and/or plasma reactants are supplied to the surface of the workpiece while the workpiece is heated to specific temperatures.

Typically, higher temperatures aid in achieving higher reaction rates, and therefore higher workpiece throughput. On the other hand, higher temperatures can sometimes cause damage to structures on partially fabricated integrated circuits. Additionally, certain chemical reactions are most efficiently performed at lower temperatures.

Many structures and methods are known in the art for controlling workpiece temperature within the chamber. For example, radiant heat may be focused onto the workpiece through transparent "cold walls" formed of quartz. Radiant heat is often used in very high temperature processing (*e.g.*, at greater than 500°C), where it is desirable to raise and lower temperature during the process cycle for each workpiece.

In other arrangements, the temperature of the workpiece can be regulated by heating the workpiece support or chuck. Conventionally, the term "chuck" refers to a support for processing workpieces that is kept at constant temperature as workpieces are transferred in, processed, and transferred out of a processing chamber in cycles.

Some systems, particularly plasma processing systems, require cooling a chuck rather than heating in order to maintain a desired chuck temperature. Depending on the chemistry and process parameters, some plasma processes impart a significant heat load to the chuck. If the chuck does not provide means to remove this heat, the temperature of the chuck can rise above the desired set point. This typically happens in low temperature processes because the chuck temperature is close to the temperature of the surrounding chamber, and the radiative heat transfer between the chuck and the chamber is poor. The situation is made worse when the chamber temperature is even higher than the chuck temperature.

In higher temperature processes, the radiative heat transfer between the chuck and the surrounding chamber is generally sufficient to offset the heat load generated by the process. Using a liquid to both heat the chuck and remove extra heat is common in the industry. Running high temperature processes with liquid heating, however, is dangerous and not economical. Additionally, changing the chuck temperature requires changing the fluid temperature, which can be slow and can reduce throughput.

### Summary of the Invention

One method for achieving two temperature levels with a chuck is to use an electrical heat source to run high temperature processes and a liquid heat source to run low temperature processes. Such a system is disclosed, for example, in U.S. Patent No. 6,461,801. However, in such systems the liquid should be purged from the chuck when running high temperature processes to prevent boiling of the liquid within the chuck. This is typically time consuming and can decrease throughput. Thus, there remains a need for an improved system for providing temperature control of a workpiece support chuck.

Thus, according to one embodiment, a method of processing a workpiece in a processing chamber is provided. The method of this embodiment comprises heating a first chuck to a first temperature, cooling a second chuck to a second temperature below the first temperature, placing a workpiece to be processed on a support surface of the first chuck and controlling a temperature of the first chuck by adjusting a rate of heat transfer between the first chuck and the second chuck.

In one embodiment, adjusting a rate of heat transfer comprises varying a distance physically separating the first chuck from the second chuck. Varying a distance physically separating the first chuck from the second chuck can comprise placing the chucks in direct physical contact with one another. In another embodiment, adjusting a rate of heat transfer comprises varying a flow of a gas into a space between the first chuck and the second chuck. In yet another embodiment, adjusting a rate of heat transfer comprises varying a parameter affecting a rate at which heat is removed from the second chuck. For example, a flow rate of a cooling fluid circulating through the second chuck can be adjusted.

Another embodiment provides an apparatus for supporting a workpiece in a process chamber. The apparatus of this embodiment comprises a heater coupled to a first chuck having a surface for supporting the workpiece. The apparatus further comprises a second chuck having a cooling device coupled thereto. The second chuck is thermally couplable to the first chuck to vary a rate of heat transfer between the first chuck and the second chuck. In some embodiments, the apparatus further comprises an automatic control system configured to control a temperature of the first chuck by varying a rate of heat transfer between the first and second chucks.

Yet another embodiment provides a method of processing a workpiece in an apparatus comprising a first heated chuck and a second cooled chuck. The method of this embodiment comprises placing the workpiece on the first chuck, positioning the second chuck at a first position relative to the first chuck, and performing a first process on the workpiece at a first temperature. The second chuck is then moved relative to the first chuck until the second chuck is at a second position relative to the first chuck, and a second process is performed on the workpiece at a second temperature.

In yet another embodiment, a method of processing a workpiece in an apparatus comprising a first chuck and a second chuck is provided. The method of this embodiment comprises positioning the workpiece on the first chuck, with the second chuck positioned a first distance away from the first chuck. The method comprises initiating a photoresist strip process on the workpiece, changing a temperature of the first chuck by moving the second chuck to a position a second distance away from the first chuck, and continuing to perform the photoresist strip process on the workpiece.

In still another embodiment, a method comprises performing a first photoresist strip process on a first batch of workpieces at a first temperature, moving a second chuck towards the first chuck, and performing a cleaning process on a second batch of workpieces at a second temeperature lower than the first temperature.

### Brief Description of Drawings

Having thus summarized the general nature of the invention, embodiments and modifications thereof will become apparent to those skilled in the art from the detailed description herein having reference to the figures that follow, of which:

FIG. 1 is a schematic illustration of a temperature-controlled dual chuck apparatus;

FIG. 2 is a schematic cross-sectional view of a dual-chuck apparatus situated within a processing chamber;

FIG. 3 is a schematic, perspective, cross-sectional, exploded view of the system of Figure 2;

FIG. 4 is a flow chart illustrating one method of using a dual chuck apparatus;

FIG. 5 is a flow chart illustrating another method of using a dual chuck apparatus;

FIG. 6 is a flow chart illustrating another method of using a dual chuck apparatus; and

FIG. 7 is a flow chart illustrating still another method of using a dual chuck apparatus.

### Detailed Description of the Preferred Embodiments

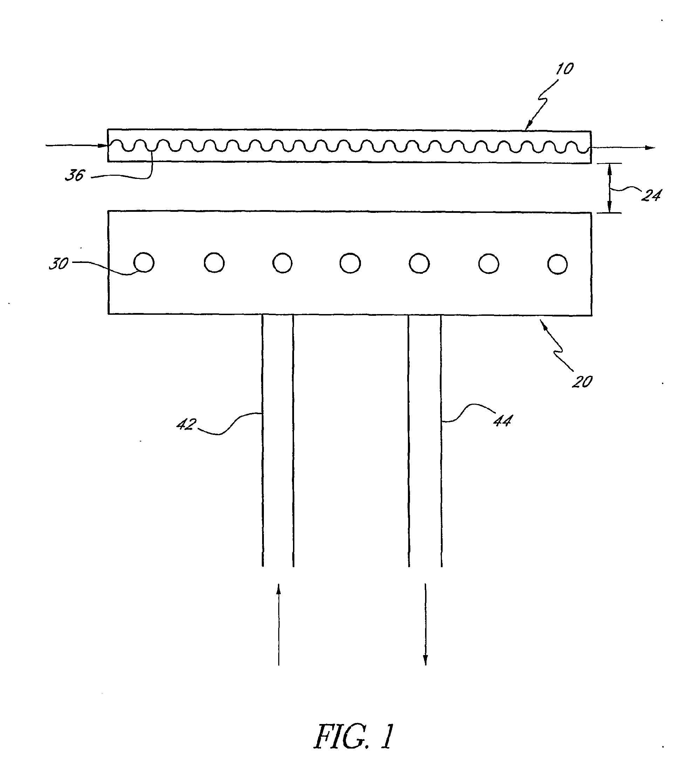

With reference to the attached figures, some preferred embodiments of a temperature-controlled apparatus for supporting a workpiece comprise a heat source configured to input heat to a workpiece support and a heat sink configured to remove heat from the support. In one embodiment, illustrated for example in Figure 1, the heat source can be provided in a first chuck 10 upon which a workpiece can be supported, and the heat sink can be provided in a second chuck 20 positioned adjacent the first chuck 10.

In general, the first chuck (or "hot chuck") 10 is configured to be actively heated and is configured to support a workpiece on its upper surface (or on support pins extending upwards therefrom). The second chuck (or "cold chuck") 20 is generally maintained at a temperature below that of the first chuck 10 and is configured to remove heat from the hot chuck 10 through radiative, convective and/or conductive heat transfer. The rate of heat transfer between the hot chuck and the cold chuck can be varied by adjusting any one of a number of parameters such as a distance separating the chucks 10, 20; a temperature of, or rate of heat transfer from, the cold chuck; a quantity or composition of gas occupying a space between the chucks, or other parameters recognized by the skilled artisan.

In the embodiment illustrated in Figure 1, the hot chuck 10 is heated by electrical heating elements 36 embedded within the chuck 10. The skilled artisan will be able to select a suitable heating element or other heat source for use in a workpiece chuck as described herein. One example of a chuck with a heating element is described in U.S. Patent No. 6,660,975. Alternatively, the hot chuck can be heated by other means, such as radiative heaters, fluid heaters, thermoelectric devices, etc.

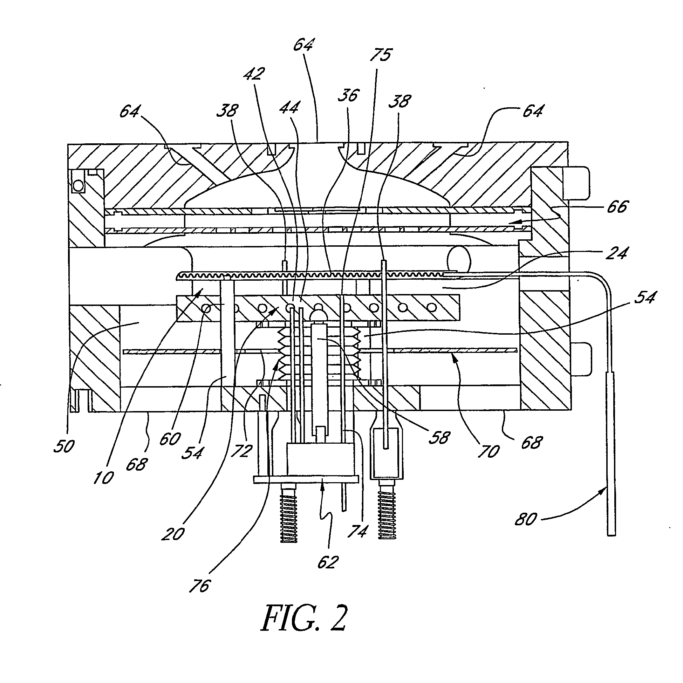

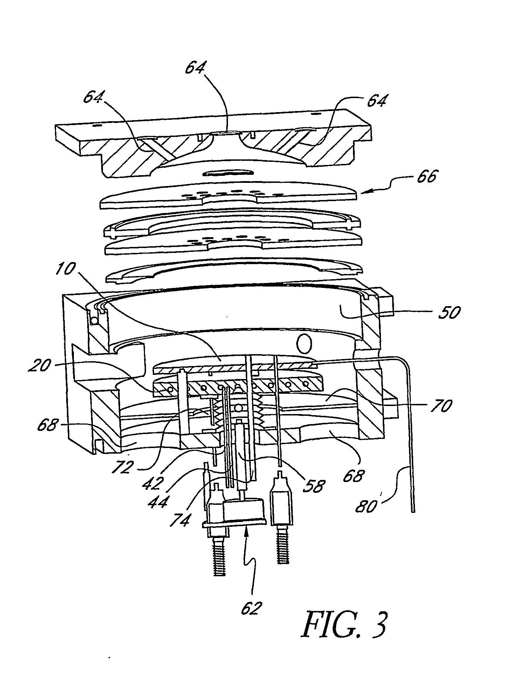

The hot chuck 10 can have any suitable construction. For example, the chuck 10 may include vacuum channels for holding the workpiece in place, or the workpiece can be held in place solely by gravity. The hot chuck 10 can be made of any suitable material, typically one having a high thermal conductivity. In one embodiment, the hot chuck 10 is formed of a ceramic material such as aluminum nitride (AlN), and has a mass of between about 700 grams and about 2500 grams, and in one preferred embodiment a mass of about 1200 grams. A1N is a desirable material for use in the present system for its relatively high thermal conductivity, rigidity at high temperatures, and resistance to corrosion. Alternatively, the hot chuck 10 can be made of any other suitable metallic or ceramic material. In the illustrated embodiment, the hot chuck 10 is held stationary or fixed with respect to a chamber 50 (see Figures 2 and 3) within which it is situated. However, in alternative embodiments, the hot chuck 10 can be configured to be movable within the process chamber.

The cold chuck 20 can likewise be made of any suitable material. In one embodiment, the material of the cold chuck 20 is selected to have a high thermal conductivity, and in some embodiments, the cold chuck 20 is also selected to have a high mass and a high thermal capacity (i.e. the product of the specific heat and the density of a material) relative to the hot chuck 10, which preferably has a relatively low mass and thermal capacity. In one embodiment, the cold chuck 20 is formed of pure aluminum or an aluminum alloy and has a mass of between about 3,000 grams and about 10,000 grams, and in one preferred embodiment a mass of about 5,000 grams. Thus, in some embodiments, the hot chuck can advantageously have a mass that is between about 20% and about 30% of the mass of the cold chuck. In some preferred embodiments, the hot chuck has a mass of between about 23% and about 28% of the mass of the cold chuck, and in one particular embodiment, the mass of the hot chuck is about 24% of the mass of the cold chuck.

In one embodiment, it is particularly desirable to provide a hot chuck made of an A1N ceramic with a mass of about 1,200 grams in combination with a cold chuck made of aluminum with a mass of about 5,000 grams. These materials have uniquely desirable physical and thermal properties relative to one another. Alternatively, other materials with substantially large thermal capacities such as beryllium, boron, chromium, copper, etc can also be used in suitable masses. However, metals other than Al are typically provided with a protective plating in order to survive in the plasma environment and to avoid metal contamination during semiconductor processing. In one embodiment as discussed in more detail below, the cold chuck 20 is desirably movable with respect to the hot chuck 10 so as to increase or decrease a separation (or gap) 24 between the hot and cold chucks 10, 20.

In the embodiment illustrated in Figure 1, fluid flow channels 30 are provided in the cold chuck 20. It will be understood that the channels 30 can be connected in series to define a single flow path winding through the chuck 20, or in parallel to provide a plurality of fluid flow paths through the cold chuck 20. A thermal transfer fluid, such as water, a water and ethylene glycol mixture, or other suitable cooling gas or liquid, is circulated within the cold chuck 20 to cool the chuck 20.

Such a fluid-cooled system also typically includes a pump or other device for circulating cooling fluid through the channels 30 in the cold chuck 20. A fluid source (not shown) storing thermal transfer fluid at a relatively low temperature communicates with the fluid channels in the cold chuck 20 via a supply line 42 and a return line 44. A flow control valve (not shown) can be provided in the fluid line to adjust a flow rate of the thermal transfer fluid through the cold chuck 20. Alternatively, a flow rate of the thermal transfer fluid can be controlled by varying a pumping rate or other parameter.

In still further alternative embodiments, the cold chuck 20 can be cooled by other methods or devices as desired. For example, the cold chuck can be cooled by thermoelectric coolers (TEC's) or any other device capable of removing heat from an object.

With reference now to FIGURES 2 and 3, the hot chuck 10 and the cold chuck 20 are shown within a process chamber 50. As shown legs 54 can be provided to extend between the hot chuck 10 and a bottom surface of the chamber 50 in order to support the hot chuck 10 within the chamber 50. Alternatively, the hot chuck 10 can be supported in any other manner recognized as suitable. In some embodiments, the position of the hot chuck 10 can be fixed relative to the process chamber 50. Alternatively, the hot chuck can be configured to be movable within the chamber in addition to or instead of the cold chuck 20. A number of lift pins 38 can be provided to lift the workpiece off the hot chuck 10 during workpiece loading and unloading.

As shown in Figures 2 and 3, the cold chuck 20 is supported below the hot chuck 10 by a central column 58. The column 58 extends from a center of the cold chuck 20 through a bottom of the process chamber 50 to a position-control system 62. A number of through holes 60 can be provided in the cold chuck 20 to allow the legs 54 of the hot chuck 10 to extend therethrough to the bottom surface of the chamber 50. Alternatively, the first chuck 10 can be supported peripherally such as on brackets extending from the side walls of the chamber 50 or in any other suitable manner.

Inlet passages 64 are typically provided through a top of the chamber 50 to allow process gases to enter the chamber 50 through an inlet baffle plate 65 and a shower head plate 66. Exhaust passages 68 can be provided through a bottom of the chamber 50. As shown, a center-draw baffle 70 having a central opening 72 can be provided below the cold chuck 20. The baffle 70 causes process gases to flow more uniformly over the workpiece from the inlet passages 64 to the exhaust passages 68.

In one embodiment as shown in Figure 2, a flexible bellows 76 is provided surrounding the column 58 in order to isolate a fluid supply line 42, a fluid return line 44, a gas supply line 74, and the support column 58 from the process gases in the chamber 50. The bellows 76 is also preferably configured to flex as the cold chuck 20 moves vertically within the chamber in order to maintain a difference in atmosphere between the chamber 50 and the space within the bellows 76. The bellows 76 can be formed of any suitable corrosion resistant material, such as an INCONEL^{™} alloy or other nickel-based alloy. The fluid supply line 42 and the fluid return line 44 extend alongside the column 58 through the bellows 76 to the cold chuck 20. A gas supply line 74 preferably also extends through the bellows 76 alongside the support column 58 to supply inert gas into the gap 24 between the chucks 10, 20. In one embodiment, as shown, the gas supply line can terminate in a gas outlet 75. In alternative embodiments, the gas 74 and/or fluid 42, 44 lines can be routed through a center of the support column, through a leg 54, or through any other structure such that the desired fluid communication is provided to the cold chuck 20 and/or the gap 24 between the chucks. In further alternative embodiments gas and/or fluid lines can extend through a side wall of the chamber, and may be exposed directly to the process gases (provided the lines are of a suitable material to resist damage from the process gases). Embodiments in which fluid lines extend through side walls are particularly useful for systems in which the cold chuck is stationary in the chamber.

In the illustrated embodiment, the cold chuck 20 is vertically movable relative to the hot chuck 10. Any suitable motor and position control apparatus can be provided to drive the support column 58 and cold chuck 20 towards or away from the hot chuck 10, as desired. For example, in some embodiments the central column 58 can be raised and lowered by a rack and pinion or a worm screw. Alternatively, the cold chuck 20 can be supported by a plurality of movable supports rather than a single column.

With reference to FIGURES 1-3, methods of operation of embodiments of a temperature-controlled workpiece support will now be described. Embodiments of a temperature-controlled workpiece support advantageously allow rapid heating and cooling of the hot chuck 10 over a wide range of temperatures. The temperature of the hot chuck 10 can generally be increased by increasing a power to the heater 36 within the hot chuck 10 (or by changing a temperature or flow rate of a fluid in a fluid-heated system). Reducing the temperature of the hot chuck 10 can be accomplished by varying a rate of heat transfer from the hot chuck 10 to the cold chuck 20. The rate of heat transfer between the hot chuck 10 and the cold chuck 20 can be varied by adjusting any one of a number of parameters such as a size of the gap 24 separating the chucks 10, 20; a temperature of the cold chuck; a quantity or type of gas occupying a space between the chucks, or other parameters recognized by the skilled artisan.

In one preferred embodiment, an inert gas is continuously injected into the gap 24 between the chucks. This allows heat to be transferred from the hot chuck to the cold chuck by "free convection" and (to some extent) conduction through the gas. The skilled artisan will recognize that (among other factors), the type of gas and a rate of injection and/or removal of the gas will affect the rate of heat transfer between the chucks. If the chucks 10, 20 are brought into physical contact, conduction becomes the dominant mode of heat transfer between them. The skilled artisan will recognize that conductive heat transfer is dependent on the difference in temperature and the specific heats of the chuck materials as well as other factors. Thus, in one preferred embodiment the temperature of the hot chuck 10 is controlled by increasing or decreasing (possibly to zero) the gap 24 between the chucks 10, 20.

The term "thermally couple" is used herein in its ordinary sense and refers without limitation to the act of increasing a rate of heat transfer between the hot chuck and the cold chuck to or above a desired level. The skilled artisan will recognize that a maximum rate of heat transfer can be achieved by bringing the hot and cold chucks into direct physical contact. However, a desired level of heat transfer sufficient to "thermally couple" the chucks can be less than the maximum possible for a given system. Thus, in some embodiments, the chucks are considered to be "thermally coupled" when they are in proximity (e.g. less than about 2mm) to one another, but are not physically contacting one another. Similarly, the term "thermally decouple" is used in its ordinary sense and refers without limitation to the act of reducing a rate of heat transfer between the hot chuck and the cold chuck to a desired minimum. The skilled artisan will recognize that a desired minimum rate of heat transfer may not necessarily be the absolute minimum that a given system is capable of achieving.

For high temperature processes (*e.g.*, at greater than about 110°C), the rate of heat transfer from the hot chuck to the cold chuck can be increased by thermally decoupling the chucks. In some embodiments, the chucks are thermally de-coupled by moving the cold chuck 20 downward away from the hot chuck 10. In one embodiment, the cold chuck 20 is thermally decoupled from the hot chuck 10 when it is moved to a position at least about 0.5 inches (~1.27 cm) away from the hot chuck 10. In further embodiments, the chucks can be configured to be thermally decoupled when the chucks 10, 20 are separated by a smaller or greater distance, or when another parameter such as a flow rate of a cooling fluid or of a gas injected into a gap between the chucks is adjusted to a particular level.

For low temperature processes (*e.g.,* at less than about 110°C), the cold chuck 20 is moved upwardly, or towards the hot chuck 10. Preferably, the cold chuck 20 is movable into contact with the hot chuck 10 to increase a rate of heat transfer between the hot chuck 10 and the cold chuck 20. In still further alternative embodiments, intermediate thermally conducting or insulating structures or materials can be placed between the hot and cold chucks in order to vary a rate of heat transfer therebetween.

In one embodiment, a desired temperature of the hot chuck 10 is controlled by an external closed-loop temperature controller (not shown) configured to receive a temperature measurement from a thermocouple 80 and to control parameters affecting the heat transfer rate as discussed above. If the measured temperature of the hot chuck 10 is higher than a desired temperature, the controller can reduce or turn off the power to the heating elements 36. The controller can also raise the cold chuck 20 upwardly towards the hot chuck 10 to thermally couple the chucks 10, 20.

In some embodiments, the cold chuck 20 is thermally coupled to the hot chuck 10 when the cold chuck is moved to a position less than 0.5 inches (12.7 mm) away from the hot chuck 10. In one particular embodiment, the cold chuck 20 is thermally coupled to the hot chuck 10 when it is moved into contact with the hot chuck 10. When the cold chuck 20 contacts the hot chuck 10, the temperature of the hot chuck 10 typically drops sharply due to its low mass and thermal capacity in comparison to that of the cold chuck 20. The temperature of the cold chuck 20 rises only moderately due to its high mass and high thermal capacity.

As discussed above, an inert gas can be supplied between the hot chuck 10 and the cold chuck 20 to increase the rate of heat transfer between the chucks 10, 20 when a gap exists therebetween. For example, even when the chucks 10, 20 are in physical contact with one another, gaps may exist as a result of rough variations in the mating surfaces of the chucks. The skilled artisan will recognize that heat will be transferred across any gap faster if a gas is present than would be the case in a vacuum. Therefore, in some embodiments, an inert gas can be selected to have as high a thermal conductivity as possible. Temperature equilibrium between the chucks 10, 20 can thus be reached relatively quickly.

In order to maintain the temperature of the hot chuck 10 within a desired range, the controller can adjust system parameters to increase or decrease the rate at which heat is transferred from the hot chuck 10 and thereby to increase or decrease the temperature of the hot chuck 10. According to one embodiment, if the measured temperature of the hot chuck 10 is less than the desired temperature, the controller reactivates the heating elements 36 of the hot chuck 10 to increase the temperature of the hot chuck 10. The desirably low mass and thermal capacity of the hot chuck 10, allows the temperature of the hot chuck 10 to be changed rapidly. If the measured temperature is greater than the desired temperature of the hot chuck 10, the heating elements 36 can remain deactivated while the thermal transfer fluid circulates through the cold chuck 20 to remove additional heat from the chucks 10, 20.

In some embodiments, the illustrated workpiece support apparatus can be employed within a microwave plasma asher for stripping organic photoresist from integrated circuit workpieces. The asher can employ a remote microwave plasma source which produces oxygen and/or fluorine radicals upstream of the process chamber. Alternatively, the apparatus can employ an internal radio frequency (RF) plasma generator within the process chamber 50.

As previously noted, some embodiments of the illustrated apparatus are particularly useful for photoresist stripping and/or cleaning operations. Photoresist is applied and removed from a workpiece at various stages of semiconductor fabrication. As described in the following examples, the illustrated apparatus has utility in many resist strip contexts. For example, the illustrated apparatus is particularly useful for two-step photoresist strip processes in which one processing step is carried out at a higher temperature than another. By adjusting a rate of heat transfer between the hot and cold chucks 10, 20, one processing step can be carried out immediately after another without having to remove the workpiece from the process chamber 50. In addition, different batches of workpieces can be processed at different temperatures using the illustrated apparatus. A first batch of workpieces can be processed in the chamber 50 at a first temperature. Then, by adjusting the distance between the chucks 10, 20 (or another parameter affecting the rate of heat transfer between the chucks), a second batch of workpieces can be processed in the chamber 50 at a second temperature immediately thereafter.

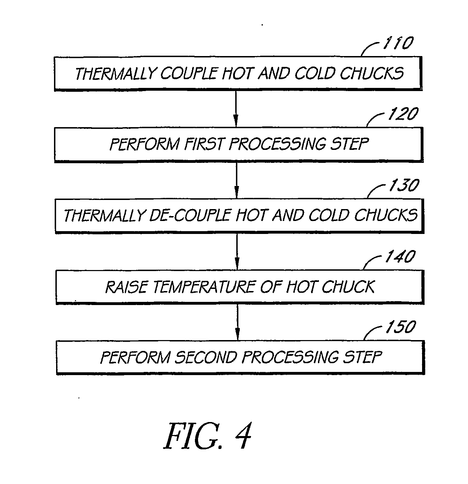

Figure 4 illustrates one example of a method of using a temperature-controlled workpiece support system in a two-step post-implant resist strip process. During initial stages of semiconductor fabrication, regions of a semiconductor substrate are implanted with dopants (e.g. boron, phosphorous, arsenic) through a photoresist mask. Ion implantation is similarly performed through masks in many other doping steps. The ion implantation process results in a hardened crust at the top surface of the photoresist. Outgassing during high temperature steps can be trapped by the hardened crust until an explosive pressure is built within the photoresist, potentially causing damage to both the partially fabricated workpiece as well as the reactor. Traditionally, utilizing a low temperature strip process to avoid excess gas build-up has minimized this risk.

Thus, in one example of a resist strip process, the hot and cold chucks are thermally coupled 110 while thermal transfer fluid circulates through the cold chuck 20, and an initial strip is first conducted 120 at low temperature until the trapping crust is removed from the photoresist. Workpiece temperatures during the initial step are preferably kept between about 100°C and 140°C, more preferably between about 110°C and 125°C. Reaction gases can include an oxidant to aid oxidation of the resist (*e.g.*, O₂, preferably converted to oxygen radicals); a fluorine source to aid removal of the implanted portion (*e.g.,* NF₃ or CF₄, preferably converted to fluorine radicals); and a diluting gas (such as He or Ar) and/or forming gas (H₂/N₂) to serve as a carrier. Reactants can be supplied to the workpiece surface in any suitable fashion. Radicals can be generated in a remote microwave plasma generator or any other suitable plasma source. The implanted upper portion of the resist is typically removed in about thirty (30) seconds.

Once the crust has been removed, the hot and cold chucks are thermally de-coupled 130, the temperature of the hot chuck 10 rises 140 and the reaction continues 150. Preferably, the temperature is raised to between about 150°C and 300°C and more preferably between about 200°C and 250°C. During this higher temperature step, the cold chuck 20 is preferably thermally decoupled from the hot chuck 10. For example, the cold chuck 20 can be moved at least about 0.5 inches (12.7 mm) away from the hot chuck 10. Once the hot chuck 10 is separated from the cold chuck 20, the electrical heating elements 36 cause the temperature of the hot chuck 10 to rise. The same reactant chemistry can continue to flow during the second stage of the strip. However, in some embodiments N₂ (or forming gas) flows with O₂ and fluorine flow can be discontinued. The raised temperature results in a significantly increased etch rate, thereby improving workpiece throughput. In particular, a temperature of about 250°C results in a strip rate of about 7 µm/min. A typical photoresist mask of about 1 µm can therefore be removed within about 5 to 10 seconds.

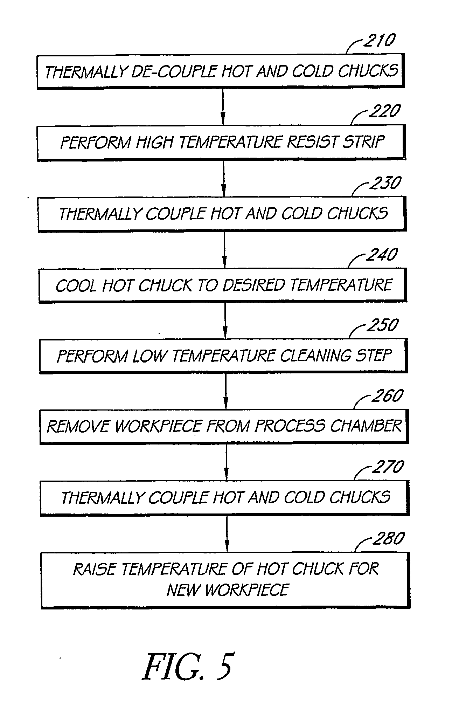

With reference now to Figure 5, one example of a method of using a temperature-controlled workpiece support system in a post-via resist strip process will be described. At various stages during some semiconductor fabrication processes, vias can be created through layers, typically through insulating layers such as borophosphosilicate glass (BPSG) or oxides formed from tetraethylorthosilicate (TEOS). A photoresist mask is selectively exposed and developed in a desired pattern and the developed or undeveloped resist is removed, depending upon whether positive or negative resist is employed. Vias are then formed through the patterned photoresist mask and through the exposed portions of the underlying layer, typically an oxide.

After via formation, the photoresist mask is removed. Unfortunately, the process of forming the via creates an organic residue within the via, which is often difficult to remove. The residue is often referred to in the industry as a polymer "veil," and is particularly problematic following reactive ion etching of vias for back-end or metallization stages of fabrication. While relatively vigorous cleaning chemistries are often employed to remove this polymer residue, over-etching of the structure risks damage to the exposed features within the via. Accordingly, it is advantageous to conduct the post-via formation cleaning after rapid resist stripping at relatively low temperatures.

With the hot and cold chucks thermally de-coupled 210, and with the hot workpiece chuck 10 at an elevated temperature (*e.g.*, 200°C to 250°C), a high temperature resist strip 220 can be conducted at rapid rates, as disclosed above with respect to the second stage of the post-implant process. Reactants can also be provided as discussed in previous examples above, with optional fluorine flow. In one embodiment, the thermal decoupling is achieved by moving the cold chuck 20 at least 0.5 inches (12.7 mm) away from the hot chuck 10.

The illustrated two-chuck system allows the post-via cleaning to be conducted within the same process chamber as the high temperature resist strip 220. Accordingly, after the high temperature resist strip 220, the hot and cold chucks can be thermally coupled 230 and the "hot" chuck 10 can be cooled 240 for a low temperature cleaning process 250. During the post-strip clean process, the workpiece temperature is typically kept between about room temperature and about 100°C, more preferably between about 50°C and 80°C. The chemistry during this process preferably includes an oxidant (*e.g.,* O₂), a diluting gas (*e.g.,* He, Ar, and/or forming gas such as N₂/H₂), and a fluorine source gas (*e.g.,* NF₃ or CF₄). The fluorine, while aiding removal of the polymer, also attacks the oxide sidewalls of the via. The oxidant and fluorine reactants can comprise radicals formed upstream of the reaction chamber.

The post-strip clean process can utilize RF plasma generation within the chamber, compensating for reduced temperatures during the process. N₂ or forming gas aid maintenance of the plasma discharge. Additionally, an optional physical sputter etch can be briefly applied immediately after treatment with the oxygen and fluorine sources.

Upon completion of the via cleaning step 250, the workpiece is removed 260 from the chamber 50. The cold chuck 20 and the hot chuck 10 are then thermally decoupled 270 and the hot chuck 10 is again heated 280 in preparation for processing another workpiece.

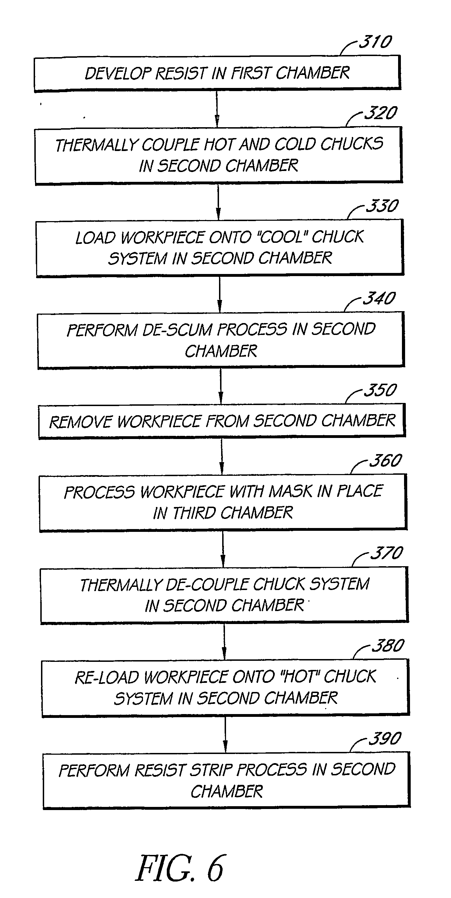

Figure 6 illustrates one example of a method of using a temperature-controlled workpiece support system in a de-scum process as will be described. As discussed above, at various stages of some semiconductor fabrication processes, a photoresist mask is selectively exposed and developed in a desired pattern and the developed or undeveloped resist is removed (depending upon whether positive or negative resist is employed). After removing the developed or undeveloped photoresist, a thin polymer residue often remains. A cleaning or "de-scum" process is desirably performed to remove the residue prior to etching or other masked process (*e.g.,* ion implantation).

Thus, in the embodiment illustrated in Figure 6, the resist layer is developed 310 in a first developing chamber (not shown). After or during the development step, the chucks 10, 20 of the dual chuck system in the processing chamber 50 are thermally coupled 320, and the workpiece support chuck 10 is cooled to a desired "cool" temperature: The workpiece is then loaded 330 onto the "cool" chuck system, and a de-scum process is performed 340 at the "cool" temperature. The de-scum process is preferably performed at relatively low temperatures (*e.g.*, at about 100°C) to avoid removal of the photoresist mask. Upon completion of the de-scum process, the workpiece can be removed 350 from the chamber 50 and moved to another chamber for a masked process or etching step 360. After or during the masked processing step 360, the hot and cold chucks 10, 20 of the dual chuck system can be thermally de-coupled 370 and raised to a desired "high" temperature. The workpiece can then be re-loaded 380 into the process chamber 50, and a resist strip process can be performed 390.

The skilled artisan will recognize that workpieces can be processed according to the processes described herein in a "batch mode" or an individual mode. For example, in one embodiment, a single wafer can be processed through the method illustrated in Figure 6 before beginning processing of a new wafer. Alternatively, two or more workpieces can be moved between the various process chambers of Figure 6 for simultaneous processing. Thus, a batch of workpieces can be cycled through the two chambers in order to minimize overhead time of one or both chambers. As will be understood by the skilled artisan in view of the disclosure here, in yet another arrangement, a batch of workpieces can be processed with the dual chuck system in the process chamber 50 at a "cool" temperature before de-coupling the chucks and processing a batch of wafers at a "high" temperature. Such batch or individual processing cycles can also be applied to processes in which a high temperature process is followed by a low temperature process (with or without an intermediate process performed in a different chamber).

With reference again to Figure 5, one example of a method of using a temperature-controlled workpiece support system to reduce loss of silicon or other oxides is described. As discussed above with respect to the post-via stripping process, residues in vias formed by RIE during back-end metallization are cleaned after the photoresist stripping. However, contact openings or holes are also formed at many other stages of integrated circuit fabrication, whether by wet etch, dry vapor etch or RIE.

Integrated circuits include many dielectric elements for electrical isolation of conductive elements. A common material for such dielectric elements is silicon oxide in various forms, although silicon nitride is also popular for many applications.

In forming electrical contacts among conductive elements, the contact holes or openings are formed through insulating layers known as interlevel dielectrics (ILDs). Opening contact holes to active areas within semiconductor substrates often exposes insulative sidewall spacers over transistor gate electrodes. Such contact etches typically also expose sacrificial oxide over the substrate. In each of these examples, masks are employed to define the hole or via, and an etch process exposes oxide surfaces.

Such oxide surfaces define dimensions selected by a circuit design. As device packing density continues to increase in pursuit of faster integrated circuit (IC) operating speeds and lower power consumption, it becomes ever more important to maintain these dimensions, and tolerance for overetch is commensurately reduced. Thus, it is increasingly important that cleaning the openings after removal of the photoresist mask be carefully controlled to avoid overetch of the exposed insulating surfaces, particularly oxide surfaces.

Accordingly, one embodiment of a method of reducing oxide loss comprises thermally de-coupling 210 the hot and cold chucks and then conducting a first stage of post-contact etch resist stripping 220 at high temperatures (preferably between about 100°C and 300°C, more preferably between about 200°C and 250°C). An exemplary reactant flow includes 1:10 ratios of N₂:O₂.

After the post-contact etch resist strip 220, the dual-chuck apparatus can be employed to perform a lower temperature post-strip clean. Accordingly, the hot and cold chucks are thermally coupled 230, the hot chuck is cooled 240 to a desired temperature, and a post-strip clean process is performed 250. As noted with respect to the post-via cleaning, fluorine aids in cleaning oxide surfaces of lithography by-products. Desirably, a relative small percentage of fluorine gas source (*e.g.*, less than about 5% CF₄) is added to the flow.

Advantageously, employing an RF plasma, in addition to the remote plasma generator, lowers the required process temperature for a given etch rate. The temperature of the hot chuck 10 is preferably maintained between about 15°C and 100°C, more preferably between about 20°C and 100°C, and most preferably between about 25°C and 50°C during the low temperature cleaning step 250. Despite rapid etch rates, the post-strip clean can be strictly controlled by limiting the time for which the RF electrodes are powered (*e.g.*, for about 15 seconds).

In addition to the examples of two stage processes discussed above, the two-chuck apparatus of Figures 1-3 can advantageously increase workpiece throughput for any desired process, including single-temperature processes which are conducted at high temperatures. Such increased throughput can be achieved by improving the speed and efficiency of a post-process cooling of the workpiece.

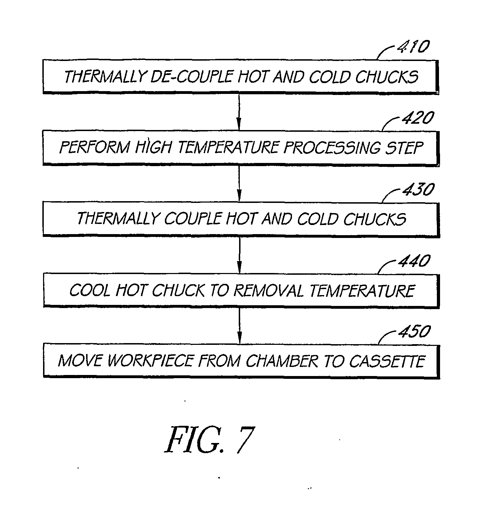

For such processes, illustrated for example in Figure 7, a rapid resist strip process 420 (preferably between about 100°C and 300°C, more preferably between about 200°C and 250°C) can be followed by lowering the workpiece temperature 440 while the workpiece is still situated on the chuck 10 to levels tolerable by commercial storage cassettes. The method generally comprises thermally coupling 430 the cold chuck 20 with the hot chuck 10 to lower the temperature of the workpiece and the hot chuck 10 to a desired removal temperature 440. In some embodiments, the workpiece and chuck are cooled to a temperature less than about 100°C, and in one embodiment to less than about 70°C. The workpiece can thus be removed 450 from the chuck 10 and the chamber 50 and placed directly into a low temperature storage cassette without any waiting beyond the time required to open the chamber gate valve and extend the transfer robot to lift the workpiece.

Accordingly, several advantages inhere in the described apparatus. For example, processes that require two-step processing at different temperatures can be efficiently conducted within the same process chamber. Furthermore, workpiece throughput can be increased by eliminating a separate cooling station conventionally used for cooling workpieces prior to placement in a low-cost storage cassette.

## Claims

1. An apparatus for supporting a workpiece in a process chamber, the apparatus comprising a heater coupled to a first chuck having a surface for supporting said workpiece, and a second chuck having a cooling device coupled thereto, the second chuck being thermally couplable to the first chuck to vary a rate of heat transfer between said first chuck and said second chuck.

2. The apparatus of claim 1, further comprising a control system programmed to control a temperature of the first chuck by varying a rate of heat transfer between the first and second chucks.

3. The apparatus of claim 1, wherein the cooling device comprises a fluid path extending through the second chuck for circulating a thermal transfer fluid therethrough.

4. The apparatus of claim 1, wherein said second chuck is coupled to a position control apparatus configured to selectively move the second chuck towards and away from said first chuck.

5. The apparatus of claim 1, wherein the heater comprises an electrical resistance heating element.

6. The apparatus of claim 1, further comprising at least one fluid outlet configured to inject a gas into a space between the first and second chucks.

7. The apparatus of claim 6, wherein the fluid outlet is in an upper surface of the second chuck.

8. The apparatus of claim 1, wherein said second chuck is arranged in said process chamber vertically below said first chuck.

9. The apparatus of claim 1, wherein the second chuck comprises an upper surface configured to be moved into contact with a lower surface of the first chuck.

10. The apparatus of claim 1, wherein the second chuck is movable at least a distance of 0.5 inches (1.27 cm) away from the first chuck.

11. The apparatus of claim 1, wherein the second chuck is supported by a central column surrounded by a bellows.

12. The apparatus of claim 1, wherein the second chuck is made of aluminum or an aluminum alloy.

13. The apparatus of claim 12, wherein said first chuck is fabricated from a ceramic material.

14. The apparatus of claim 13, wherein said ceramic material is aluminum nitride.

15. A method of processing a workpiece in an apparatus or in a processing chamber comprising a first heated chuck and a second cooled chuck, the method comprising the steps of:
- placing the workpiece on said first chuck;
- positioning said second chuck at a first position relative to said first chuck;
- performing a first process on said workpiece at a first temperature;
- moving said second chuck relative to said first chuck until said second chuck is at a second position relative to said first chuck; and
- performing a second process on said workpiece at a second temperature.

16. The method of claim 15, wherein moving said second chuck comprises vertically moving said second chuck relative to the first chuck.

17. The method of claim 15, further comprising injecting a gas into a space between the first and second chucks.

18. The method of claim 15, further comprising pumping a cooling fluid through the second chuck.

19. The method of claim 15, further comprising applying power to an electrical resistance heater in the first chuck.

20. The method of claim 15, wherein said first temperature is less than said second temperature, and said first position is closer to the first chuck than the second position.

21. The method of claim 15, further comprising removing the workpiece from the chamber.

22. The method of claim 21, wherein positioning the second chuck at the first position comprises placing the second chuck in contact with the first chuck.

23. The method of claim 21, wherein the first process is a low temperature resist strip.

24. The method of claim 21, wherein the first process is a de-scum process.

25. The method of claim 24, further comprising removing the workpiece from the chamber after the de-scum process and performing a second process with a resist mask in place in a second chamber.

26. The method of claim 25, further comprising returning the workpiece to the chamber and performing a third process at a high temperature.

27. The method of claim 26, wherein the third process is a resist strip process.

28. The method of claim 15, wherein said first temperature is greater than said second temperature, and said first position is further from the first chuck than the second position.

29. The method of claim 28, wherein positioning the second chuck at the first position comprises positioning the second chuck at least 0.5 inches (1.27 cm) below the first chuck.

30. The method of claim 28, wherein the first process is a high temperature resist strip process.

31. The method of claim 28, wherein the second process is a low temperature cleaning process.

32. The method of claim 15, wherein the first process includes initiating a photoresist strip process and the second process includes continuing to perform said photoresist strip process.

33. The method of claim 32, wherein said first position is closer to the first chuck than said second position, and said first temperature is less than said second temperature.

34. The method of claim 32, wherein said first position is further away from the first chuck than said second position, and said first temperature is greater than said second temperature.

35. The method of claim 15, wherein the first process includes performing a first photoresist strip process on a first batch of workpieces on the first chuck while the second chuck is at the first position, the second process includes performing a cleaning process on a second batch of workpieces, wherein said second temperature is lower than said first temperature while the second chuck is at the second position relative to said first chuck and the second position is closer to the first chuck than the first position.

36. The method of claim 35, wherein said first temperature is between about 150°C and 300°C.

37. The method of claim 35, wherein said cleaning process includes a de-scum process performed on said second batch of workpieces after developing photoresist masks on said workpieces, but prior to conducting a process on said workpieces through the photoresist masks.

38. The method of claim 15, wherein performing the first process comprises heating the first chuck to the first temperature.

39. The method of claim 38, wherein performing the first process further comprises cooling the second chuck to a temperature below the first temperature.

40. The method of claim 39, wherein performing the first process further comprises adjusting a rate of heat transfer between the first chuck and the second chuck to control the first temperature.

41. The method of claim 40, wherein adjusting a rate of heat transfer comprises varying a flow of gas into a space between the first chuck and the second chuck.

42. The method of claim 40, wherein adjusting a rate of heat transfer comprises varying a parameter affecting a rate at which heat is removed from the second chuck.

43. The method of claim 40, wherein adjusting a rate of heat transfer comprises varying a flow rate of a cooling fluid circulating through the second chuck.

## Patentansprüche

1. Vorrichtung zum Tragen eines Werkstückes in einer Bearbeitungskammer, wobei die Vorrichtung eine mit einem ersten Trägerelement, das eine Oberfläche zum Tragen des Werkstückes aufweist, gekoppelte Heizung und ein zweites Trägerelement aufweist, das eine damit gekoppelte Kühlvorrichtung aufweist, wobei das zweite Trägerelement mit dem ersten Trägerelement thermisch koppelbar ist, um eine Wärmeübertragungsrate zwischen dem ersten Trägerelement und dem zweiten Trägerelement zu variieren.

2. Vorrichtung nach Anspruch 1, weiterhin mit einem Steuerungssystem, das so programmiert ist, dass es eine Temperatur des ersten Trägerelements durch Variation einer Wärmeübertragungsrate zwischen dem ersten und dem zweiten Trägerelement steuert.

3. Vorrichtung nach Anspruch 1, wobei die Kühlvorrichtung einen Fluidpfad aufweist, der sich durch das zweite Trägerelement zur Zirkulation eines Wärmeübertragungsfluids durch dieses hindurch erstreckt.

4. Vorrichtung nach Anspruch 1, wobei das zweite Trägerelement mit einer Positionssteuervorrichtung gekoppelt ist, die so ausgestaltet ist, dass das zweite Trägerelement wahlweise zu dem ersten Trägerelement hin und von diesem weg bewegt wird.

5. Vorrichtung nach Anspruch 1, wobei die Heizung ein elektrisches Widerstandsheizelement aufweist.

6. Vorrichtung nach Anspruch 1, weiterhin mit zumindest einem Fluidauslass, der dazu ausgelegt ist, ein Gas in einen Raum zwischen dem ersten und dem zweiten Trägerelement zu injizieren.

7. Vorrichtung nach Anspruch 6, wobei der Fluidauslass in einer oberen Oberfläche des zweiten Trägerelements vorhanden ist.

8. Vorrichtung nach Anspruch 1, wobei das zweite Trägerelement in der Bearbeitungskammer vertikal unter dem ersten Trägerelement angeordnet ist.

9. Vorrichtung nach Anspruch 1, wobei das zweite Trägerelement eine obere Oberfläche aufweist, die dazu ausgelegt ist, in Berührung mit einer unteren Oberfläche des ersten Trägerelements bewegt zu werden.

10. Vorrichtung nach Anspruch 1, wobei das zweite Trägerelement zumindest über eine Strecke von 0,5 Zoll (1,27 cm) von dem ersten Trägerelement weg bewegbar ist.

11. Vorrichtung nach Anspruch 1, wobei das zweite Trägerelement durch eine mittige Säule, die von einem Balg umgeben ist, gehalten ist.

12. Vorrichtung nach Anspruch 1, wobei das zweite Trägerelement aus Aluminium oder einer Aluminiumlegierung gehalten ist.

13. Vorrichtung nach Anspruch 12, wobei das erste Trägerelement aus einem Keramikmaterial hergestellt ist.

14. Vorrichtung nach Anspruch 13, wobei das Keramikmaterial Aluminiumnitrid ist.

15. Verfahren zum Bearbeiten eines Werkstückes in einer Vorrichtung oder in einer Bearbeitungskammer, die ein erstes geheiztes Trägerelement und ein zweites gekühltes Trägerelement aufweist, wobei das Verfahren die Schritte aufweist:
- Anordnen des Werkstückes auf dem ersten Trägerelement;
- Positionieren des zweiten Trägerelements in einer ersten Position relativ zu dem ersten Trägerelement;
- Durchführen einer ersten Bearbeitung an dem Werkstück bei einer ersten Temperatur;
- Bewegen des zweiten Trägerelements relativ zu dem ersten Trägerelement, bis das zweite Trägerelement in einer zweiten Position relativ zu dem ersten Trägerelement ist; und
- Durchführen einer zweiten Bearbeitung an dem Werkstück bei einer zweiten Temperatur.

16. Verfahren nach Anspruch 15, wobei das Bewegen des zweiten Trägerelements ein vertikales Bewegen des zweiten Trägerelements relativ zu dem ersten Trägerelement aufweist.

17. Verfahren nach Anspruch 15, weiterhin mit dem Schritt Injizieren eines Gases in einen Raum zwischen dem ersten und dem zweiten Trägerelement.

18. Verfahren nach Anspruch 15, weiterhin mit dem Schritt Pumpen eines Kühlfluides durch das zweite Trägerelement.

19. Verfahren nach Anspruch 15, weiterhin mit dem Schritt Beaufschlagen einer elektrischen Widerstandsheizung im dem ersten Trägerelement mit Spannung.

20. Verfahren nach Anspruch 15, wobei die erste Temperatur geringer ist als die zweite Temperatur ist, und wobei die erste Position näher an dem ersten Trägerelement ist als die zweite Position.

21. Verfahren nach Anspruch 15, weiterhin mit dem Schritt Entnehmen des Werkstückes aus der Kammer.

22. Verfahren nach Anspruch 21, wobei das Positionieren des zweiten Trägerelements in der ersten Position ein Anordnen des zweiten Trägerelements in Berührung mit dem ersten Trägerelement aufweist.

23. Verfahren nach Anspruch 21, wobei die erste Bearbeitung eine Niedertemperatur-Fotolackentfernung ist.

24. Verfahren nach Anspruch 21, wobei die erste Bearbeitung eine Entschäumung ist.

25. Verfahren nach Anspruch 24, weiterhin mit dem Schritt Entnehmen des Werkstückes aus der Kammer nach der Entschäumung und Durchführen einer zweiten Bearbeitung mit einer Fotolackmaske an Ort und Stelle in einer zweiten Kammer.

26. Verfahren nach Anspruch 25, weiterhin mit dem Schritt Rückführen des Werkstückes zu der Kammer und Durchführen einer dritten Bearbeitung bei einer hohen Temperatur.

27. Verfahren nach Anspruch 26, wobei die dritte Bearbeitung eine Fotolackentfernung ist.

28. Verfahren nach Anspruch 25, wobei die erste Temperatur größer ist als die zweite Temperatur, und wobei die erste Position von dem ersten Trägerelement weiter entfernt ist als die zweite Position.

29. Verfahren nach Anspruch 28, wobei das Positionieren des zweiten Trägerelements in der ersten Position den Schritt Positionieren des zweiten Trägerelements zumindest 0,5 Zoll (1,27 cm) unterhalb des ersten Trägerelements aufweist.

30. Verfahren nach Anspruch 28, wobei die erste Bearbeitung eine Hochtemperatur-Fotolackentfernung ist.

31. Verfahren nach Anspruch 28, wobei die zweite Bearbeitung eine Niedertemperatur-Reinigung ist.

32. Verfahren nach Anspruch 15, wobei die erste Bearbeitung ein Beginnen einer Fotolackentfernung und die zweite Bearbeitung ein Fortsetzen der Durchführung der Fotolackentfernung umfasst.

33. Verfahren nach Anspruch 32, wobei die erste Position näher an dem ersten Trägerelement als die zweite Position ist, und wobei die erste Temperatur niedriger als die zweite Temperatur ist.

34. Verfahren nach Anspruch 32, wobei die erste Position von dem ersten Trägerelement weiter entfernt als die zweite Position ist, und wobei die erste Temperatur höher ist als die zweite Temperatur.

35. Verfahren nach Anspruch 15, wobei die erste Bearbeitung ein Durchführen einer ersten Fotolackentfernung an einer ersten Charge von Werkstücken auf dem ersten Trägerelement umfasst, während das zweite Trägerelement in der ersten Position ist, wobei die zweite Bearbeitung ein Durchführen einer Reinigung an einer zweiten Charge von Werkstücken umfasst, wobei die zweite Temperatur niedriger als die erste Temperatur ist, während das zweite Trägerelement in der zweiten Position relativ zu dem ersten Trägerelement ist und die zweite Position näher an dem ersten Trägerelement ist als die erste Position.

36. Verfahren nach Anspruch 35, wobei die erste Temperatur zwischen etwa 150°C und 300°C liegt.

37. Verfahren nach Anspruch 35, wobei die Reinigung eine Entschäumung umfasst, die an einer zweiten Charge von Werkstücken durchgeführt wird, nachdem Fotolackmasken auf den Werkstücken entwickelt worden sind, jedoch vor dem Durchführen einer Bearbeitung an den Werkstücken durch die Fotolackmasken hindurch.

38. Verfahren nach Anspruch 15, wobei das Durchführen der ersten Bearbeitung ein Aufheizen des ersten Trägerelements auf die erste Temperatur aufweist.

39. Verfahren nach Anspruch 38, wobei das Durchführen der ersten Bearbeitung weiterhin ein Kühlen des zweiten Trägerelements auf eine Temperatur unter der ersten Temperatur aufweist.

40. Verfahren nach Anspruch 39, wobei das Durchführen der ersten Bearbeitung weiterhin ein Einstellen einer Wärmeübertragungsrate zwischen dem ersten Trägerelement und dem zweiten Trägerelement aufweist, um die erste Temperatur zu steuern.

41. Verfahren nach Anspruch 40, wobei das Einstellen einer Wärmeübertragungsrate ein Variieren eines Gasflusses in einen Raum zwischen dem ersten Trägerelement und dem zweiten Trägerelement aufweist.

42. Verfahren nach Anspruch 40, wobei das Einstellen einer Wärmeübertragungsrate ein Variieren eines Parameters aufweist, der eine Rate beeinflusst, bei der Wärme von dem zweiten Trägerelement entfernt wird.

43. Verfahren nach Anspruch 40, wobei das Einstellen einer Wärmeübertragungsrate ein Variieren einer Flussrate eines Kühlfluids aufweist, das durch das zweite Trägerelement hindurch zirkuliert.

## Revendications

1. Dispositif pour supporter une pièce dans une chambre de traitement, le dispositif comprenant un réchauffeur couplé à un premier mandrin ayant une surface pour supporter ladite pièce et un deuxième mandrin auquel est couplé un dispositif de refroidissement, le deuxième mandrin pouvant être couplé thermiquement au premier mandrin pour faire varier un débit de transfert de chaleur entre ledit premier mandrin et ledit deuxième mandrin.

2. Dispositif selon la revendication 1, comprenant, en outre, un système de régulation programmé pour réguler une température du premier mandrin en faisant varier un débit de transfert de chaleur entre le premier et le deuxième mandrins.

3. Dispositif selon la revendication 1, dans lequel le dispositif de refroidissement comprend une voie de passage de fluide s'étendant à travers le deuxième mandrin pour faire circuler un fluide de transfert de chaleur à travers.

4. Dispositif selon la revendication 1, dans lequel ledit deuxième mandrin est couplé à un dispositif de régulation de position configuré pour faire avancer le deuxième mandrin vers ledit premier mandrin et pour l'éloigner de celui-ci de manière sélective.

5. Dispositif selon la revendication 1, dans lequel le réchauffeur comprend un élément chauffant à résistance électrique.

6. Dispositif selon la revendication 1, comprenant, en outre, au moins un orifice de sortie de fluide configuré pour injecter un gaz dans un espace entre le premier et le deuxième mandrins.

7. Dispositif selon la revendication 6, dans lequel l'orifice de sortie de fluide se trouve dans une surface supérieure du deuxième mandrin.

8. Dispositif selon la revendication 1, dans lequel ledit deuxième mandrin est agencé verticalement dans ladite chambre de traitement en dessous dudit premier mandrin.

9. Dispositif selon la revendication 1, dans lequel le deuxième mandrin comprend une surface supérieure configurée pour être amenée en contact avec une surface inférieure du premier mandrin.

10. Dispositif selon la revendication 1, dans lequel le deuxième mandrin peut être éloigné du premier mandrin sur au moins une distance de 0,5 pouce (1,27 cm).

11. Dispositif selon la revendication 1, dans lequel le deuxième mandrin est supporté par une colonne centrale entourée par un soufflet.

12. Dispositif selon la revendication 1, dans lequel ledit premier mandrin est fait en aluminium ou en un alliage d'aluminium.

13. Dispositif selon la revendication 12, dans lequel le deuxième mandrin est fabriqué dans une matière céramique.

14. Dispositif selon la revendication 13, dans lequel ladite matière céramique est du nitrure d'aluminium.

15. Procédé pour le traitement d'une pièce dans un dispositif ou dans une chambre de traitement comprenant un premier mandrin chauffé et un deuxième mandrin refroidi, le procédé comprenant les étapes de :
- positionnement de la pièce sur ledit premier mandrin ;
- positionnement dudit deuxième mandrin dans une première position par rapport audit premier mandrin ;
- réalisation d'un premier traitement sur ladite pièce à une première température ;
- déplacement dudit deuxième mandrin par rapport audit premier mandrin jusqu'à ce que ledit deuxième mandrin se trouve dans une deuxième position par rapport audit premier mandrin ; et
- réalisation d'un deuxième traitement sur ladite pièce à une deuxième température.

16. Procédé selon la revendication 15, dans lequel le déplacement du deuxième mandrin comprend le déplacement vertical dudit deuxième mandrin par rapport au premier mandrin.

17. Procédé selon la revendication 15, comprenant, en outre, l'injection d'un gaz dans un espace entre le premier et le deuxième mandrins.

18. Procédé selon la revendication 15, comprenant, en outre, le pompage d'un fluide de refroidissement à travers le deuxième mandrin.

19. Procédé selon la revendication 15, comprenant, en outre, l'application d'une puissance à un réchauffeur à résistance électrique dans le premier mandrin.

20. Procédé selon la revendication 15, dans lequel ladite première température est inférieure à ladite deuxième température et ladite première position est plus près du premier mandrin que la deuxième position.

21. Procédé selon la revendication 15, comprenant, en outre, l'enlèvement de la pièce hors de la chambre.

22. Procédé selon la revendication 21, dans lequel le positionnement du deuxième mandrin dans la première position comprend la mise en contact du deuxième mandrin avec le premier mandrin.

23. Procédé selon la revendication 21, dans lequel le premier traitement est un décapage à basse température de la couche de réserve.

24. Procédé selon la revendication 21, dans lequel le premier traitement est un traitement d'écumage.

25. Procédé selon la revendication 24, comprenant, en outre, l'enlèvement de la pièce hors de la chambre après le traitement d'écumage et la réalisation d'un deuxième traitement avec un masque réserve en place dans une deuxième chambre.

26. Procédé selon la revendication 25, comprenant, en outre, le retour de la pièce dans la chambre et la réalisation d'un troisième traitement à une température élevée.

27. Procédé selon la revendication 26, dans lequel le troisième traitement est un traitement de décapage de la couche de réserve.

28. Procédé selon la revendication 15, dans lequel ladite première température est supérieure à ladite deuxième température et ladite première position est plus éloignée du premier mandrin que la deuxième position.

29. Procédé selon la revendication 28, dans lequel le positionnement du deuxième mandrin dans la première position comprend le positionnement du deuxième mandrin à au moins 0,5 pouce (1,27 cm) en dessous du premier mandrin.

30. Procédé selon la revendication 28, dans lequel le premier traitement est un décapage à haute température de la couche de réserve.

31. Procédé selon la revendication 28, dans lequel le deuxième traitement est un traitement de nettoyage à basse température.

32. Procédé selon la revendication 15, dans lequel le premier traitement comprend le démarrage d'un traitement de décapage de la résine photosensible et le deuxième traitement comprend la poursuite de la réalisation dudit traitement de décapage de la résine photosensible.

33. Procédé selon la revendication 32, dans lequel ladite première position est plus près du premier mandrin que ladite deuxième position et ladite première température est inférieure à ladite deuxième température.

34. Procédé selon la revendication 32, dans lequel ladite première position est plus éloignée du premier mandrin que ladite deuxième position et ladite première température est supérieure à ladite deuxième température.

35. Procédé selon la revendication 15, dans lequel le premier traitement comprend la réalisation d'un premier traitement de décapage de la résine photosensible sur un premier lot de pièces sur le premier mandrin pendant que le deuxième mandrin se trouve dans la première position, le deuxième traitement comprend la réalisation d'un traitement de nettoyage sur un deuxième lot de pièces, dans lequel, ladite deuxième température est inférieure à ladite première température pendant que le deuxième mandrin se trouve dans la deuxième position par rapport audit premier mandrin et la deuxième position est plus près du premier mandrin que la première position.

36. Procédé selon la revendication 35, dans lequel ladite première température est comprise entre environ 150°C et 300°C.

37. Procédé selon la revendication 35, dans lequel ledit traitement de nettoyage comprend un traitement d'écumage réalisé sur ledit deuxième lot de pièces après le développement de masques photorésistants sur lesdites pièces, mais avant la réalisation d'un traitement sur lesdites pièces à travers les masques photorésistants.

38. Procédé selon la revendication 15, dans lequel la réalisation du premier traitement comprend le chauffage du premier mandrin à la première température.

39. Procédé selon la revendication 38, dans lequel la réalisation du premier traitement comprend, en outre, le refroidissement du deuxième mandrin à une température inférieure à la première température.

40. Procédé selon la revendication 39, dans lequel la réalisation du premier traitement comprend, en outre, l'ajustement d'un débit de transfert de chaleur entre le premier mandrin et le deuxième mandrin pour réguler la première température.

41. Procédé selon la revendication 40, dans lequel l'ajustement d'un débit de transfert de chaleur comprend la variation d'un flux de gaz dans un espace entre le premier mandrin et le deuxième mandrin.

42. Procédé selon la revendication 40, dans lequel l'ajustement d'un débit de transfert de chaleur comprend la variation d'un paramètre affectant un débit selon lequel la chaleur est évacuée du deuxième mandrin.

43. Procédé selon la revendication 40, dans lequel l'ajustement d'un débit de transfert de chaleur comprend la variation d'un débit d'un fluide de refroidissement circulant à travers le deuxième mandrin.
